# EUROPEAN PATENT SPECIFICATION

(11) **EP 3 304 608 B1**
(45) Date of publication and mention of the grant of the patent: **18.11.2020**
(21) Application number: 16730285.0
(22) Date of filing: 03.06.2016
(51) Int. Cl.: H01L 41/09, H01L 41/053, H01L 41/04

(54) **ACTUATION DEVICE**
BETÄTIGUNGSVORRICHTUNG
DISPOSITIF D'ACTIONNEMENT

(30) Priority: 03.06.2015 EP 15170384; 14.10.2015 EP 15189808
(43) Date of publication of application: 11.04.2018
(73) Proprietor: Koninklijke Philips N.V., 5656 AG Eindhoven (NL)
(72) Inventor: VAN DEN ENDE, Daan Anton, 5656 AE Eindhoven (NL); LAVEZZO, Valentina, 5656 AE Eindhoven (NL); PELSSERS, Eduard Gerard Marie, 5656 AE Eindhoven (NL); JOHNSON, Mark Thomas, 5656 AE Eindhoven (NL); HENDRIKS, Cornelis Petrus, 5656 AE Eindhoven (NL)
(74) Representative: Marsman, Albert Willem
(86) International application number: PCT/EP2016/062616
(87) International publication number: WO 2016/193412

(56) References cited:
- EP-A2- 1 014 416
- WO-A1-98/11586
- WO-A1-98/11586
- WO-A2-2004/063090
- US-A- 4 383 195
- US-B1- 6 392 331
- US-B2- 7 663 294
- US-B2- 7 737 608
- US-B2- 8 552 846
- US-B2- 8 552 846

## Description

### FIELD OF THE INVENTION

This invention relates to arrays of actuation devices that make use of an active material. It also relates to methods of operating such arrays.

### BACKGROUND OF THE INVENTION

WO 98/11586 A1 discloses a system according to the preamble of the independent claim 1, including an array of switching devices, each comprising a membrane made of a material M1 supported by a substrate made of a material M2, the material M1 being constrained with respect to the material M2 at the membrane/substrate interface, so as to curve said membrane. By piezoelectric control means, the membrane can switch between a stable concave configuration and a stable convex configuration. The switching device is useful for displaying devices.

Electro- or optoactive materials are materials that show mechanical deformation when electrically or optically driven with a suitable control signal. Certain classes of these materials also exhibit the converse effect, i.e. they can provide an electrical or optical signal when subjected to mechanical deformation. The exact mechanism by which the above effects occur is dependent on the material of choice and in some cases also on the way of embedding them an a device. Because of the above effects, the most common applications of such materials are in actuators and/or sensors.

Electroactive polymers (EAP) and optoactive polymers (OAP) are emerging an emerging classes of materials. They combine their favourable actuation-response properties with a number of advantageous engineering properties, therewith allowing use in new application areas. Thus, e.g. an EAP generally exhibits a relatively large deformation and force in a small volume or thin form factor, compared to common other mechanical actuators or actuators based on inorganic EAMs. EAPs also give noiseless operation, accurate electronic control, fast response, and the possibility of high resolution and cyclic actuation with a large range of possible actuation frequencies, such as 0 - 20 kHz. OAPs provide other advantages. And all of these properties and advantages come with easy manufacturing into various shapes using well established methods allowing easy integration into a large variety of systems.

EAPs and OAPs can be particularly advantageously used in any application in which a small amount of movement of a component or feature is desired. Similarly, the technology can be used for sensing small movements.

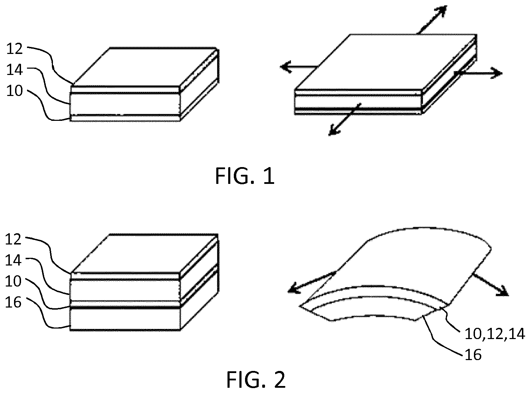

As an example of EAP device operation, Figs. 1 and 2 show two possible operating modes for an EAP based device. The device comprises an EAP layer 14 sandwiched between electrodes 10, 12 on opposite sides of the EAP layer 14. While in Fig. 1 the EAP layer is freely moveable, in Fig. 2 the whole EAP layer and its electrodes are clamped with one layer side to a support carrier layer 16. A voltage difference (drive signal) applied over the electrodes 10 and 12 is used to provide an electric field over the EAP layer to cause the EAP layer to expand in all directions as shown. While in Fig. 1 this leads to deformation of the EAP layer due to the layer being freely suspended, the same actuation in Fig. 2 leads to bending of the device due to the restrained freedom of motion by the clamping. Using device engineering a vast variety of device outputs can be invoked upon actuation of the EAP layer, i.e upon driving of the device. Thus, to obtain the asymmetric curving around an axis as shown, molecular orientation (film stretching) may for example be applied, forcing the movement in one direction. The expansion in one direction may result from the asymmetry in the EAP layer, or it may result from asymmetry in the properties of the carrier layer, or a combination of both.

An EAP or OAP based device, like those of Fig. 1 and 2 typically is analogue devices, which means that the drive vs ouput response curve is a continuous curve. Hence, any signal other than a zero level/intensity signal will lead to an actuation output. However, they require continuous driving in order to maintain their actuated state. In certain cases, it is not desired to deliver a continuous driving signal to the actuator. There is therefore a need for a device which does not need a continuous application of the driving signal to remain in its actuated state.

### SUMMARY OF THE INVENTION

It is an object of the invention to provide an array of actuation devices of the type described herein above that does not require continuous application of the driving signal in order to remain in its actuated state.

The invention provides a system and method as defined by the independent claims. The dependent claims provide advantageous embodiments.

The invention uses an actuation device comprising:
- an actuation structure comprising a carrier and an active material attached to the carrier for causing bending and/or a change of bending of at least the carrier in response to a driving of the active material;
- a mechanical structure for defining at least a first stable mechanical state and a second stable mechanical state different from the first stable mechanical state of the actuation structure by mechanically constraining the actuation structure in a bent configuration in at least one of the first and second stable mechanical states, and
- upon the driving, the actuation structure can switch from the first stable mechanical state to the second stable mechanical state.

The active material is a material that can deform or change its shape when driven electrically (with voltage, field or current).

The actuation structure includes a carrier attached to the active material such that the actuation structure provides a bending actuator. Thus driving makes it bend or bend less.

The mechanical structure constrains the actuator mechanically such that the actuator can adopt at least two different stable mechanical states.

A stable mechanical state means a mechanical state that can be, or is maintained without applying an external stimulus such as in particular the driving to the actuation device. Thus, the mechanical structure is for maintaining at least one stable mechanical state upon ceasing of the driving. The actuation structure interacts with the mechanical structure to activate the actuation device to switch from one to the other state. This means the actuation device only requires a driving when being switched and not when in a stable state.

The first stable mechanical state can be the non-driven equilibrium or rest state of the actuation structure.

This actuation device combines an actuation structure with a mechanical structure so that the actuation device can be actuated and have multiple stable states. The carrier part of the actuation structure is part of the mechanical structure, making the actuation device particularly compact. The design allows simple flat bending actuators (multilayer with at least one actuator material layer and at least one carrier layer) that do not themselves provide bistable behavior and which are usually produced in flat condition, to be incorporated in an actuation device that does have a bistable actuation behaviour.

The actuation device can thus be used to give a digital output (below a threshold there is no effect and above the threshold there is an effect of constant magnitude) or indeed a multiple level output. Hence, the actuation of an essentially analog actuation structure is transformed into a digital output. In this way, an analog drive signal is converted into a digital actuation output, and the actuated state remains after removal of the applied drive signal.

The actuation device preferably provides an actuation output, where the actuation output is based on or defined by at least the second stable mechanical state. The actuation output can comprise any kind of mechanical output such as e.g. a stroke, force, strain, pressure or displacement, where displacement can be based on a sliding, rotating, binding, twisting or expanding, in one or more directions along one or more axes, at one or more points or around one or more axes, or any one combination of the aforementioned. This may be engineered according to need with specific design of the actuation structure and/or the mechanical structure.

The actuation structure can be arranged for providing the actuation output. Alternatively of additionally, there can be an actuation output member (e.g. piston or rod or other member) having a mechanical (in contact or through forces operating) interaction with the actuation structure and/or the mechanical structure for providing the actuation output.

In one example, the actuation device is reset by externally applying a mechanical force to the actuation device. The driving then only switches between states in one direction, i.e. form the first stable state to the second stable state.

The actuation device used in the invention can further include that
- the carrier has a first side and a second side opposite to the first side, wherein the active material is attached to the first side; and
- the actuator structure comprises a further active material attached to the second side, the further active material being for causing bending and/or a change of bending of the actuation structure in response to a further driving of the active material so that, upon the further driving, the actuation structure can switch from the second stable mechanical state to the first stable mechanical state.

Thus, upon ceasing of the further driving, the mechanical structure can maintain the first stable mechanical state. This actuation device is thus driveable between two stable states, while design compactness is maintained.

The active material and the further active material can be the same or different electroactive materials.

The substrate, and any active materials preferably are arranged as a stack of layers. The active material, further active material, carrier part of the mechanical structure and optional other parts can be made in layer form stacked on top of each other. Optional parts can be those for providing the driving, such as one or more electrodes. This is a convenient design.

In one of the first and second mechanical states, the actuator is mechanically constrained in a bent configuration. The mechanically constrained actuator and particularly the carrier then can be a bi-stable part (behaving as e.g. a spring) due to the constrainment. The part can have the shape of a layer. This part or layer may for example snap between two stable states during switching. The actuation structure is substantially flat in a non-driven situation when residing in the mechanically-constrained first or second stable mechanical state, while the other state is the bent configuration.

The actuation device may comprise a housing, wherein the mechanical structure forms a lid to the housing and the actuation structure is within the housing. This provides a closed self-contained design in which the top lid provides the mechanical actuation output of the actuation device.

This design compact design is advantageous for the actuation device having the further actuation structure as even with the multiple structures (that may be in the form of layers) a compact device can be provided with bidirectional switch ability and stability

The active material and/or the further active material may extend only over a portion of the area of the carrier, for example an edge portion. The material only needs to be sufficient to cause the actuation structure to toggle between its states.

The mechanical structure may comprise a retaining device, which has a plurality of retaining positions at which the actuation structure can be retained in a stable mechanical state, each retaining position corresponding to a different actuator position at least one of the retaining positions mechanically constraining the actuation structure in the bent configuration in at least one of the first and second stable mechanical states.

By retaining the actuation structure after it has been driven, its shape is retained at least partially after the driving is ended. The retaining device may for example be for retaining a movable edge of the actuation structure at different distances from a fixed edge of the actuation structure, and comprises a plurality of retaining notches.

Actuation devices using electroactive polymers as the electroactive materials can be subdivided into field-driven and ionic-driven materials. Field-driven EAPs are actuated by an electric field through direct electromechanical coupling. They usually require high fields (volts per meter) but low currents. Polymer layers are usually thin to keep the driving voltage as low as possible. Ionic EAPs are activated by an electrically induced transport of ions and/or solvent. They usually require low voltages but high currents. They require a liquid/gel electrolyte medium (although some material systems can also operate using solid electrolytes). Both classes of EAP have multiple family members, each having their own advantages and disadvantages.

Examples of field-driven EAPs include Piezoelectric polymers, Electrostrictive polymers (such as PVDF based relaxor polymers or polyurethanes) and Dielectric Elastomers. Other examples include Electrostrictive Graft polymers, Electrostrictive paper, Electrets, Electroviscoelastic Elastomers and Liquid Crystal Elastomers.

Examples of ionic-driven EAPs are conjugated/conducting polymers, Ionic Polymer Metal Composites (IPMC) and carbon nanotubes (CNTs). Other examples include ionic polymer gels.

Optoactive materials can comprise polymers having one or more double bonds which can undergo cis-trans isomerization upon irradiation. Such bonds can be C=C, N=C or N=N bonds. Such materials can included for example stilbenes.

In certain applications, an array of actuators can be useful, for instance in positioning systems and controlled topology surfaces. However, as the driving voltages of the actuators are fairly high (above 50 V), it quickly becomes expensive to drive each actuator individually with its own driver integrated circuit.

A passive matrix array is a simple implementation of an array driving system using only row (n rows) and column (m columns) connections, and has a lower cost and complexity than active matrix variants. As only (n+m) drivers are required to address up to (n x m) actuators, this is a far more cost effective approach, and also saves cost and space of additional wiring.

Ideally, in a passive matrix device each individual actuator should be actuated up to its maximum voltage without influencing the adjacent actuators. However, in traditional EAP devices (without any voltage threshold) some crosstalk to adjacent actuators will be present. When voltage is applied to actuate one actuator, the actuators around it also experience a voltage and will partially actuate, which is an unwanted effect for many applications.

This situation is described in US 8 552 846, which considers a passive matrix driving of EAP devices without any threshold voltage or bistability. It discloses a passive matrix approach for a two level driving scheme. It provides a best actuation voltage contrast ratio of 3:1 (i.e. "non-actuated" actuators show 33% of maximum actuation voltage) so does not enable true bistable behavior. Note that a 3:1 actuation contrast ratio is equivalent to a 9:1 pressure level ratio (since the pressure level scales with voltage squared). This system however only works for two level driving. A third drive level would cause variation in the actuation level of the non-actuated EAP devices.

There are therefore limitations in the use of EAP devices in particular and actuation devices in general in addressed arrays, in particular passive matrix arrays.

According to the invention, there is provided a system comprising a plurality of actuation devices as defined above. The plurality of actuation devices preferably is arranged in columns and rows of an array. This system or array of actuation device makes use of multi-stable devices. In this way, a memory function is enabled, so that any desired matrix addressing pattern can be written and stored on the plurality of actuation devices or array of actuation devices.

Each of the plurality of actuation devices is connected to at least two signal lines for providing drive signals to the actuation device. Such signal lines can be electrodes. Each actuation device is connected to first and second signal lines, where one preferably is for providing a drive signal and the other is for providing select signals. This is helpful for matrix array arranged plurality of actuation devices.

The actuation devices are connected to a driver arrangement in a passive matrix addressing scheme. More particular, each of the plurality of actuation devices comprises an electroactive material as the active material and is connected to a first signal line and a second signal line for providing a drive signal to an actuation device; and wherein the system further comprises a driver arrangement for providing at least two possible signal levels to the first signal line and at least two possible signal levels to the second signal line, the signals being provided such that the drive signal received by an actuation device is a combination of one signal level of the first signal line and one of the second signal line, wherein only one of the four possible combined signal levels provides a switching from the first stable state to the second stable state of the actuation device.

Note that there may be more than the four combined signal levels in a multilevel drive scheme. However, there are at least four such combined levels, which result from the combination of the minimum and maximum first signal line signal level with the minimum and maximum second signal line signal levels.

Preferably for each actuation device:
the drive signal has a combined signal level below a first threshold Vbi and provides actuation from the first stable state towards the second stable state but with return to the first stable state upon removal of the drive signal;
the drive signal has a combined signal level above a second threshold provides actuation from the first stable state to the second stable state without return of the first stable state upon removal of the drive signal, and wherein the second threshold has a magnitude which is a first margin Vdr greater than the magnitude of the first threshold Vbi.

There is thus a range of drive signals which is insufficient to cause the individual actuation device to switch its stable state, and another range which does cause the actuation device to switch its state from one stable state to the other. This property can be used to prevent crosstalk between actuation devices during a sequential driving scheme resulting in loss of the previously stored actuation state. It is most convenient for a passive matrix type of addressing of the plurality of actuation devices.

In the system, the driver can be arranged to provide signal levels such that for one of the first signal line and the second signal line, the two possible signal levels are zero and the magnitude of the first threshold Vbi and, for the other of the first signal line and the second signal line, the two possible signal levels are zero and the magnitude of the first margin Vdr, wherein the non-zero signal levels have opposite polarity.

In this way, only the difference between the non-zero level signals (which is larger than each signal level (and therewith drive signal individually), because one is positive and one is negative) is sufficient to cause a change in actuation state.

The magnitude of the first threshold Vbi is preferably greater than the magnitude of the first margin Vdr. The magnitude of the first threshold Vbi may for example be at least five times the magnitude of the first margin Vdr. The smaller the first margin Vdr, the more abrupt the bistable behavior of the actuation devices, and therefore the lower the drive voltage magnitudes that are needed.

For the array of actuation devices, the actuation devices may be adapted to receive an external input in the form of a mechanical reset. This may for example comprise a pressure signal.

Alternatively, for each actuation device:
a reset drive signal having a combined drive level above a third threshold Vres may provide a reset to the first state upon removal of the drive signal.

This enables an electric rather than mechanical reset of the actuation devices. The signals provided on the first and second signal lines are then together adapted to provide a reset drive signal to the actuation devices either simultaneously or row-by-row or column-by-column.

In the system, the actuation device preferably comprises an electroactive polymer as the active material.

Examples in accordance with another aspect of the invention provide a method of operating a plurality of actuation devices according to the invention wherein each of the plurality of actuation devices comprises an electroactive material as the active material and is connected to a first signal line and a second signal line for providing a drive signal to an actuation device;
the method comprising providing at least two possible signal levels to the first signal line and at least two possible signal levels to the second signal line, the signals being provided such that the drive signal received by a actuation device is a combination of one signal level of the first signal line and one of the second signal line, wherein only one of the four possible combined signal levels provides a switching from the first stable state to the second stable state of the actuation device.

For each actuation device:
a drive signal having a combined signal level below a first threshold Vbi may provide actuation from the first stable state towards the second stable state but with return to the first stable state upon removal of the drive signal;
a drive signal having a combined signal level above a second threshold may provide actuation from the first stable state to the second stable state without return to the first stable state upon removal of the drive signal, wherein the second threshold has a magnitude which is a first margin Vdr greater than the magnitude of the first threshold Vbi,
wherein the method may then comprise:
   applying one of two possible signal levels to selected ones of the first signal lines and the second signal lines selected from zero and from the magnitude of the first threshold Vbi;
   applying one of two possible signal levels to selected one of the other of the first signal lines and the second signal lines selected from zero and from the magnitude of the first margin Vdr, wherein the non-zero signal levels have opposite polarity.

### BRIEF DESCRIPTION OF THE DRAWINGS

Embodiments of, and examples for understanding, the invention will now be described in detail with reference to the accompanying drawings, in which:
Fig. 1 shows a known electroactive polymer device which is not clamped;
Fig. 2 shows a known electroactive polymer device which is clamped to a carrier or backing layer;
Fig. 3 shows a first example of electroactive polymer device;
Fig. 4 shows a second example of electroactive polymer device;
Fig. 5 shows a third example of electroactive polymer device;
Fig. 6 shows a fourth example of electroactive polymer device;
Fig. 7 shows a fifth example of electroactive polymer device;
Fig. 8 shows a graph of output versus driving voltage of a device.

### DETAILED DESCRIPTION OF THE EMBODIMENTS

The devices of Figs. 1 and 2 are described in the introduction of this application. The device of Fig. 2 is a first example based on an electroactive polymer EAP as the active material where the active material is attached to a carrier.

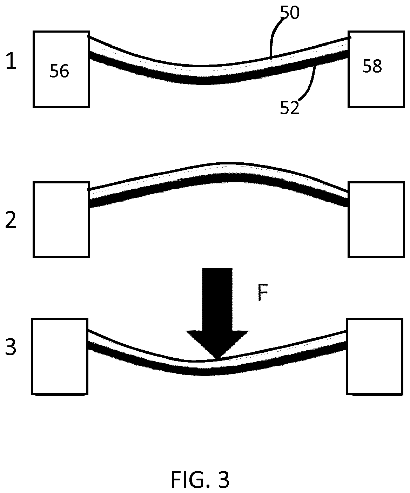

Fig. 3 shows a first EAP based device in which a substrate sheet (carrier) 50 is combined with an actuation material 52 including an EAP so that the bi-stable device constitutes an EAP in combination (joined) with a substrate. This constitutes an actuator structure as described with reference to Fig. 2. Thus there is an electrode arrangement that can receive a drive signal to perform driving of the EAP. The driving causes the structure to bend. The substrate or carrier is part of the mechanical structure which further includes the parts 56 and 58 between which the actuator is constrained horizontally (clamped or fixed) such that the substrate (and in this case also the entire actuation structure) are bent somewhat even when no driving signal is applied. When the EAP is actuated the EAP-carrier combination transfers from state 1 to state 2. After switching, actuation driving is stopped and the EAP-substrate combination remains in state 2 (state 1 for the dielectric device). Hence the actuation structure is retained in state 2. It is noted that no prestressing of the substrate is needed perse, meaning that when the actuation sturcutre is not constrained between parts 56 and 58, it can be substantially flat. Hence regular, easy to make, actuation structures can be employed to create a device that is both bistable and compact. The use of a single EAP can mean that an external force is needed to reset the device to its initial state, see state 3 of Fig. 3 where th earrow indicates an external force applied. This device could be useful in an interactive device such as a button on a user interface (UI).

The actuation structure may thus switch between concave and convex shapes. Any terms "above" and "below", or "up" and "down", or "upwardly" and "downwardly" as used below should be understood accordingly, in that they simply represent relative conditions.

The parts 56 and 58 can be part of a fixture or frame. This in turn may be present in or part of a housing of a larger device.

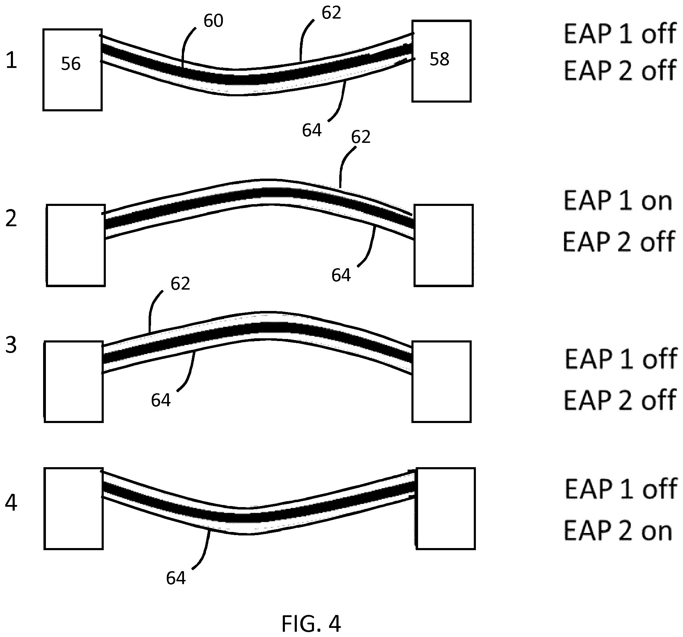

Fig. 4 shows a modification to the system of Fig. 3, in which a bistable mechanical sheet 60 is combined (attached to) with two actuation layers 62 (including EAP1) and 64 (including EAP2) so that the bi-stable device includes two EAPs as an integral part of a buckling disk or substrate clamped between the fixed ends 56 and 58. The use of two EAPs means that a reversible device is made possible using the driving. This device in effect includes a first actuation structure (with EAP 62) and a second actuation structure (with EAP 64) that share the carrier 60.

The device functions in the same way as the device of Fig. 3, but the further actuation material is used for resetting the disk back to the original state using another driving signal, instead of an external force or a pressure line. Connection to a driving arrangement and driving can be done. Thus such a device can have two drive signal inputs, one for the actuation structure and one for the further actuation structure. In this case both structures are electrically driven using a driver arrangement. Thus, each of the structures comprises two electrodes; one on either side of the EAP layer. In order to reduce the input leads to the electrodes, one electrode of the actuation structure and one electrode of the further actuation structure are electrically connected. They can be kept at the same voltage preferably zero volt/ground. Then only two input electrodes, one from the actuation structure and one from the further actuation structure can be used to put voltages to either of the other two remaining electrodes. Creating a voltage difference between the common electrode and one of the remaining electrodes will either actuate the actuation structure, or the further actuation structure. If the active materials are different, then the connected electrodes can be disconnected to give more drive freedom. This will however require more complicated drivers.

Fig. 4 shows the various steps in activating the actuator, showing that only during switching from one state to another state is any EAP activation required. The obtained effect, i.e. the movement of the buckling actuator, is a digital effect with only two states. During the EAP actuation the change in states occurs.

In step 1 the device starts in a stable state with a downward deformation, and no activation of the EAP layers.

In step 2 the actuation of only the top EAP 62 is shown to switch the state to the upwardly deformed state.

In step 3 the device remains in a stable state with the upward deformation, with no activation of the EAP layers.

In step 4 the actuation of only the bottom EAP 64 switches the state to the downwardly deformed state.

In Figs. 3 and 4, the mechanically bistable layer and the electroactive polymer layer(s) are joined together to form a sheet structure. This joining together can be achieved using glue or other means of attachement.

As an alternative to the device of Figure 4 where the actuators share the carrier, there can be used two separated actuators each of the form of Fig 3 and then oriented with respect to each other in such a way that the carriers are back to back.

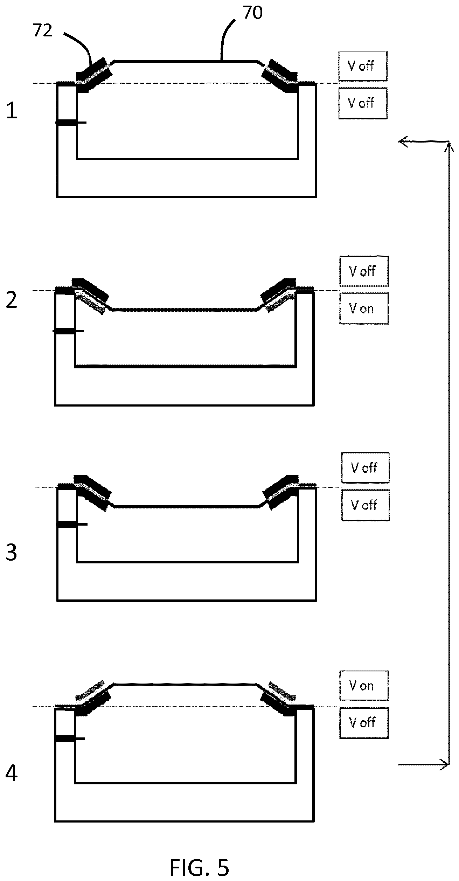

Fig. 5 shows a modification to the device of Fig. 4 in which the EAPs 72, 74 are provided at opposite sides of the rim of a bistable mechanical sheet (substrate) 70.

This example uses the same principle of providing a reversible effect by using two EAP layers, but their length is limited to only part of the surface of the buckling disk. The EAP layers only need to be sufficient to induce the desired mechanical movement.

The electroactive polymer layer(s) in this way only extend over a portion of the area of the mechanically bistable layer, for example an edge portion.

Fig.5 shows four steps in the cycle of operation of the device.

In step 1 the device starts in a stable state with an upward deformation, and no activation of the EAP layers.

In step 2 the actuation of only the bottom EAP 74 is shown to switch the state to the downwardly deformed state.

In step 3 the device remains in a stable state with the downward deformation, with no activation of the EAP layers.

In step 4 the actuation of only the top EAP 72 switches the state to the upwardly deformed state.

Only during switching from one stable state to another is the EAP activation required, thereby providing the buckling actuator with a digital movement with only two states. During the EAP actuation the change in states occurs.

The actuators in the invention can be in the form of stacks of layers comprising actuator material and carrier in alternating fashion. These subsequent layers may all be attached to eachother. Thus the actuator of Figs. 3 or 4 may actuatlly comprise multiple layers 50 and 52 or 60, 62 and 64 in alternating fashion.

Fig. 5 shows a venting hole for pressure evenign in case of switching.

The examples above make use of a mechanical structure which deforms between stable states. The mechanical structure is sufficiently rigid to retain the EAP layer or layers in a deformed state even when their driving signal is ceased.

An alternative is to hold the EAP layer in a certain position after the drive signal has been removed by using a latch type structure. For example, the mechanical structure may comprise a retaining device, which has a plurality of retaining positions at which the electroactive polymer layer can be retained in a non-driven state, each retaining position corresponding to a different actuator position. In effect, this corresponds to a situation where one of the fixed ends 56 or 58 in Figs 3 and 4 of the previous examples has multiple locations relative to the other fixed end. Each of the retaining positions is thus defined by a quasi fixed end.

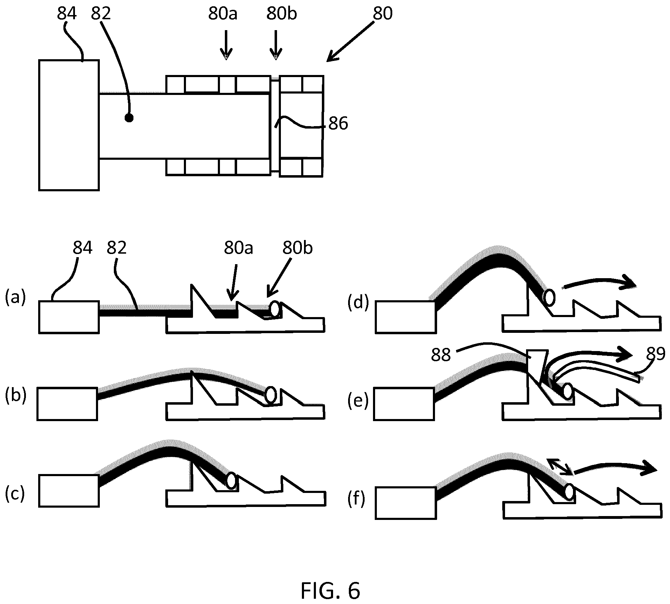

Fig. 6 shows an example in which the mechanical structure comprises a retaining device 80, which has a plurality of retaining positions 80a, 80b (two in this example shown) at which the electroactive polymer layer can be retained in a non-driven state, each retaining position corresponding to a different actuator position.

The device is shown in plan view in Fig. 6(a). Figs 6(b) to 6(d) show the device being driven from one actuator position to the other.

The EAP layer 82 is shown as a two layer structure, with an EAP part and a carrier, but it does not include a mechanically bistable element as in the examples above. The bistable property is given by the retaining device 80.

The EAP layer has a first edge part which is fixed as shown by support 84 and an opposite edge 86 which is movable, in particular into one of the notches 80a, 80b.

Actuation of the EAP layer is used to move the edge 86 of the EAP layer into one of the notches, to pass from one stable state to the other.

When the EAP is actuated, it will deflect upwards. Due to this deflection, the right edge will move inward. The moving edge 86 has a bar which moves over the notched rail. The notches are formed in such a manner that the edge of the EAP cannot travel back easily once it has passed over a notch. In a non-driven state, the notch still catches the edge of the EAP layer, preventing it from travelling back to its original position.

This leads two or more stable states in an actuation sequence.

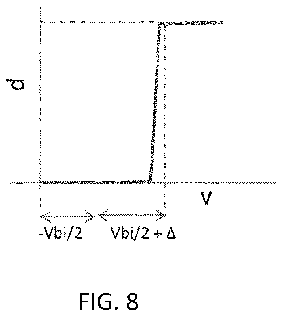

Fig. 6(b) shows the most distal notch position being used. When actuation of the EAP layer is started, the layer begins to deform as shown in Fig. 8(c), Eventually, the edge is brought over the ridge leading to the proximal notch position as shown in Fig. 8(d).

The device can be reset electrically or mechanically.

The ridge after the innermost notch is higher, and this can be used for a reset function as shown in Fig. 6(e).

The edge bar is raised up the higher ramp and this is followed by a quick release, whereby the bar travels over the other notches back to the original state.

Fig. 6(f) shows how a return guide 88 and guard rail 89 may be added to assist the EAP in travelling over the other notches, back to its original position.

A small AC signal may be applied to wiggle the EAP back and forth as schematically shown in Fig. 6(f), allowing the edge bar to hop over the vertical edge of the notch, back to its former state.

Alternatively, an external force may be used to reset the moving edge to its initial stable state, for example by lowering the notched rail by pressing a button.

It will be clear from the various examples above, that the invention involves converting the analogue actuation structure behavior into a digital (two state or more than two states) functionality by making the actuation structure interact with another mechanical component which serves to discretize the actuation structure movement (actuation). This mechanical component is integrated with the actuation structure.

Materials suitable for the actuation structures are known. Electro-active polymers include, but are not limited to, the sub-classes: piezoelectric polymers, electromechanical polymers, relaxor ferroelectric polymers, electrostrictive polymers, dielectric elastomers, liquid crystal elastomers, conjugated polymers, Ionic Polymer Metal Composites, ionic gels and polymer gels.

The sub-class electrostrictive polymers includes, but is not limited to:
Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

The sub-class dielectric elastomers includes, but is not limited to:
acrylates, polyurethanes, silicones.

The sub-class conjugated polymers includes, but is not limited to:
polypyrrole, poly-3,4-ethylenedioxythiophene, poly(p-phenylene sulfide), polyanilines.

Ionic devices may be based on ionic polymer - metal composites (IPMCs) or conjugated polymers. An ionic polymer - metal composite (IPMC) is a synthetic composite nanomaterial that displays artificial muscle behavior under an applied voltage or electric field.

A first notable subclass of Field driven EAPs are Piezoelectric and Electrostrictive polymers. While the electromechanical performance of traditional piezoelectric polymers is limited, a breakthrough in improving this performance has led to PVDF relaxor polymers, which show spontaneous electric polarization (field driven alignment). These materials can be pre-strained for improved performance in the strained direction (pre-strain leads to better molecular alignment). Normally, metal electrodes are used since strains usually are in the moderate regime (1-5%). Other types of electrodes (such as conducting polymers, carbon black based oils, gels or elastomers, etc.) can also be used. The electrodes can be continuous, or segmented.

Another subclass of interest of filed driven EAPs is that of Dielectric elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (10-300%). This also constrains the type of electrodes that can be used: for low and moderate strains, metal electrodes and conducting polymer electrodes can be considered, for the high-strain regime, carbon black based oils, gels or elastomers are typically used. The electrodes can be continuous, or segmented.

A first notable subclass of ionic EAPs is Ionic Polymer Metal Composites (IPMCs). IPMCs consist of a solvent swollen ion-exchange polymer membrane laminated between two thin metal or carbon based electrodes and requires the use of an electrolyte. Typical electrode materials are Pt, Gd, CNTs, CPs, Pd. Typical electrolytes are Li+ and Na+ water-based solutions. When a field is applied, cations typically travel to the cathode side together with water. This leads to reorganization of hydrophilic clusters and to polymer expansion. Strain in the cathode area leads to stress in rest of the polymer matrix resulting in bending towards the anode. Reversing the applied voltage inverts bending. Well known polymer membranes are Nafion® and Flemion®.

Another notable subclass of Ionic polymers is Conjugated/conducting polymers. A conjugated polymer actuator typically consists of an electrolyte sandwiched by two layers of the conjugated polymer. The electrolyte is used to change oxidation state. When a potential is applied to the polymer through the electrolyte, electrons are added to or removed from the polymer, driving oxidation and reduction. Reduction results in contraction, oxidation in expansion.

In some cases, thin film electrodes are added when the polymer itself lacks sufficient conductivity (dimension-wise). The electrolyte can be a liquid, a gel or a solid material (i.e. complex of high molecular weight polymers and metal salts). Most common conjugated polymers are polypyrolle (PPy), Polyaniline (PANi) and polythiophene (PTh).

An actuator may also be formed of carbon nanotubes (CNTs), suspended in an electrolyte. The electrolyte forms a double layer with the nanotubes, allowing injection of charges. This double-layer charge injection is considered as the primary mechanism in CNT actuators. The CNT acts as an electrode capacitor with charge injected into the CNT, which is then balanced by an electrical double-layer formed by movement of electrolytes to the CNT surface. Changing the charge on the carbon atoms results in changes of C-C bond length. As a result, expansion and contraction of single CNT can be observed

In more detail, IPMCs are composed of an ionic polymer like Nafion or Flemion whose surfaces are chemically plated or physically coated with conductors such as platinum or gold, or carbon-based electrodes. Under an applied voltage, ion migration and redistribution due to the imposed voltage across a strip of IPMCs result in a bending deformation. The polymer is a solvent swollen ion-exchange polymer membrane. The field causes cations travel to cathode side together with water. This leads to reorganization of hydrophilic clusters and to polymer expansion. Strain in the cathode area leads to stress in rest of the polymer matrix resulting in bending towards the anode. Reversing the applied voltage inverts the bending.

If the plated electrodes are arranged in a non-symmetric configuration, the imposed voltage can induce all kinds of deformations such as twisting, rolling, torsioning, turning, and non-symmetric bending deformation.

In all of these examples, additional passive layers may be provided for influencing the electrical and/or mechanical behavior of the EAP layer in response to an applied electric field.

The EAP layer of each unit may be sandwiched between electrodes. The electrodes may be stretchable so that they follow the deformation of the EAP material layer. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

IPMCs are composed of an ionic polymer like Nafion or Flemion whose surfaces are chemically plated or physically coated with conductors such as platinum or gold, or carbon-based electrodes. Under an applied voltage, ion migration and redistribution due to the imposed voltage across a strip of IPMCs result in a bending deformation. The polymer is a solvent swollen ion-exchange polymer membrane. The field causes cations travel to cathode side together with water. This leads to reorganization of hydrophilic clusters and to polymer expansion. Strain in the cathode area leads to stress in rest of the polymer matrix resulting in bending towards the anode. Reversing the applied voltage inverts the bending. Optoactive materials also sometimes called photo-responsive shape change materials can be found in the prior art. Examples are described in:
- Photo-Responsive Shape-Memory and Shape-Changing Liquid-Crystal Polymer Networks by Danish Iqbal, and Muhammad Haris Samiullah in Materials 2013, 6, 116-142;
- Large amplitude light-induced motion in high elastic modulus polymer actuators by Harris, K.D.; Cuypers, R.; Scheibe, P.; van Oosten, C.L.; Bastiaansen, C.W.M.; Lub, J.; Broer, D.J. in J. Mater. Chem. 2005, 15, 5043-5048;
- Synthesis of a Photoresponsive LiquidCrystalline Polymer Containing Azobenzene by Chensha Li, Chi-Wei Lo, Difeng Zhu, Chenhui Li, Ye Liu, Hongrui Jiang, in Macromol. Rapid Commun. 2009, 30, 1928-1935 2009;
- Optical Nano and Micro Actuator Technology, edited by George K. Knopf, Yukitoshi Otani, CRC Press, Taylor and Francis Group, 2013;
- Light-driven actuators based on polymer films by Sergey S. Sarkisov; Michael J. Curley; LaQuieta Huey; Aisha B. Fields; in Optical Engineering Volume 45, Issue 3, March 2006; and
- Large amplitude light-induced motion in high elastic modulus polymer actuators by Harris, K.D., Cuypers, R., Scheibe, P., Oosten, C.L. van, Bastiaansen, C.W.M., Lub, J. & Broer, D.J. (2005). Journal of Materials Chemistry, 15(47), 5043-5048;

It will be evident to the person skilled in the art that when any of the materials of the above prior art is used in the device of the invention that an appropriate part for providing the appropriate drive signal can also be incorporated.

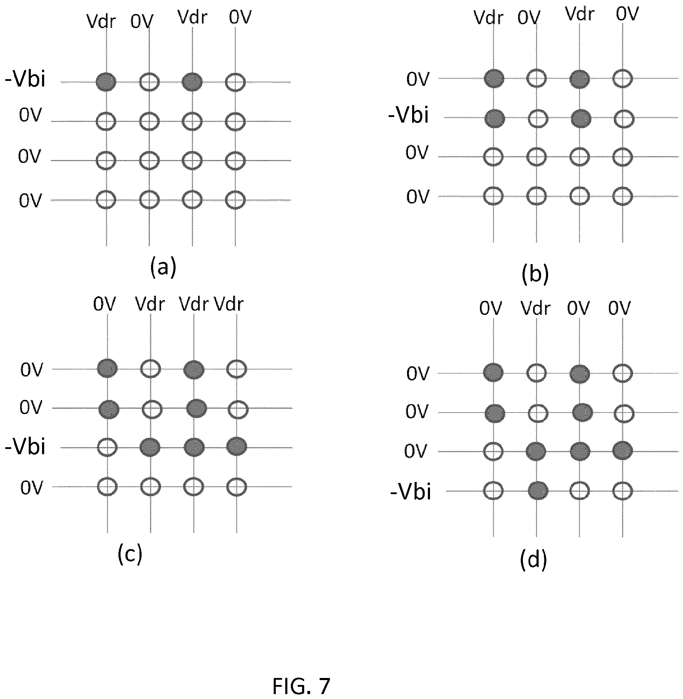

According to the invention, the actuation device is used in a passive matrix array configuration. A first example of passive matrix drive scheme is explained with reference to Fig. 7. This provides passive matrix addressing a line at a time, and with a common reset.

The array comprises a two dimensional array of rows and columns of bistable EAP devices, each with a bistable voltage (Vbi) at which a switching can just occur and reset voltage (Vres) a back swith voltage. Thus, from an initial non-actuated state, if the EAP device is driven above the bistable voltage (Vbi), the actuator will remain in its actuated state when the voltage is removed. If the EAP device is driven below (or to) the bistable voltage (Vbi), the actuator will return to its non-actuated state when the voltage is removed. Furthermore, from an initial actuated state if the EAP device is driven above a reset voltage (Vres), the actuator returns to its non-actuated state when the voltage is removed.

In preferred embodiments the bistable voltage (Vbi) exceeds the additional driving voltage range (Vdr) required to ensure that the EAP device sufficiently exceeds the bistable point and will remain actuated: namely Vbi>Vdr.

The array is driven by row drivers capable of providing 2-level addressing signals of 0V and -Vbi and column drivers capable of providing two-level data driving signals of 0V and Vdr.

Addressing the array proceeds in the manner shown in Fig. 7 where an example of a 4x4 array is considered. The addressing steps are:
1. The array of bistable EAP actuators are all in their non-actuated state.
2. All rows are initially addressed with 0V. In this situation, the maximum voltage difference across an EAP device is Vdr (the maximum voltage from a column driver). As this is below Vbi, all EAP actuators in the array will remain in the non-actuated mode after removal of the voltage.
3. The first row is addressed with -Vbi. This is shown in Fig. 7(a). Two columns are driven with voltage Vdr, and two columns are driven with 0V. In this situation, the voltage difference across two of the EAP devices is Vdr + Vbi (using the maximum voltage from a column driver, Vdr). As this is above Vbi, these two EAP actuators in the row will be driven to an actuated state which will result in the actuated state even upon removal of voltage. These two EAP devices are shown as solid circles. Non-actuated EAP devices are shown as empty circles. The voltage difference across the other two EAP devices is 0V + Vbi =Vbi (using the minimum voltage from a column driver, 0V), whereby these two EAP devices in the row will initially be in an actuated state but it will relax to the non-actuated state upon removal of voltage. This is because the EAP device must be driven to above Vbi to remain actuated when voltage is removed.
4. The second row is addressed with -Vbi as shown in Fig. 7(b). Due to the bistable nature of the EAP devices, the EAP devices in the first row remain in their state of actuation. Again, in this example the same two columns are driven with the drive voltage Vdr, and two columns are driven with 0V. In this situation, the voltage difference across two of the EAP devices is Vdr + Vbi (using the maximum voltage from a column driver, Vdr). As this is above Vbi, these two EAP devices in the second row will be in an actuated state and will remain in the actuated state upon removal of voltage. The voltage difference across the other two EAP devices is 0V + Vbi =Vbi (using the minimum voltage from a column driver, 0V), whereby these the EAP devices in the row will be in an actuated state which will revert to the non-actuated state upon removal of voltage. At the end of this phase, the desired EAP devices in the first and second rows remain actuated.
5. The third row is addressed with -Vbi as shown in Fig. 7 (c). The EAP devices in the first and second rows remain in their state of actuation since the maximum voltage is Vdr (and Vdr<Vbi). Now three columns are driven with the drive voltage Vdr, and only one column with 0V. In this situation, the voltage difference across three of the EAP devices is Vdr + Vbi (using the maximum voltage from a column driver, Vdr). As this is above Vbi, these three EAP devices in the third row will be in an actuated state which will be retained upon removal of voltage. The voltage difference across the other EAP device is 0V + Vbi =Vbi (using the minimum voltage from a column driver, 0V), whereby this EAP device in the third row will be in the actuated state which will revert to the non-actuated state upon removal of voltage. At the end of this phase, the desired EAP devices in the first, second and third rows remain actuated.
6. The fourth row is addressed with -Vbi as shown in Fig. 7(d). Again, the EAP devices in the first, second and third rows remain in their state of actuation. Now one column is driven with the drive voltage Vdr, and three columns with 0V. In this situation, the voltage difference across one of the EAP devices is Vdr + Vbi (using the maximum voltage from a column driver, Vdr) and this EAP device will be in the actuated state which will be retained upon removal of voltage. The voltage difference across the other three EAP devices is 0V + Vbi =Vbi (using the minimum voltage from a column driver, 0V), whereby these three EAP devices will be in the actuated state which will revert to the non-actuated state upon removal of voltage. At the end of this phase, the desired EAP devices in the all rows remain actuated.
7. At the end of the addressing phase, all voltages can be removed from the rows and columns and the EAP devices will remain in the same state of actuation. This is the desired bistable behavior enabling extremely low power operation of the EAP device array.
8. When a new EAP actuation pattern is required, in this embodiment a reset is applied to actuators in all rows and columns of the array.

The reset mode may be implemented by using a 3 level row or column drive voltage, so that the reset can be carried out per row or column. The driver with the lowest voltage may be used for this purpose. Alternatively, the whole array may be reset by superimposing a series voltage (Vres) on all row drivers, or alternatively a series voltage Vres-Vbi on all row drivers while addressing them all at Vbi. The row drivers can then still be 2 level drivers.

Alternatively, the reset may be performed mechanically, for example using pressure.

All EAP devices are reset to their non-actuated state. Since EAP devices are symmetric in deformation, the reset voltage must be converted to an opposing actuation in the EAP by an additional mechanism. This may be by applying a reset voltage (Vres), as explained above for actuators of the type described with reference to Fig. 6. This reset voltage may be applied to all columns with 0V applied to all rows, or -Vbi may be applied to all rows and Vres-Vbi applied to the columns. Instead, the reset may be applied to all rows, by applying -Vres to the rows and holding the columns at 0V. Any combination of voltages can be used as long as the voltage across each EAP device reaches Vres.

Alternatively, the reset can be applied by an actuator working against the functional actuator, so it is able to drive a mechanical reset. This opposing actuator could be a single actuator or set of individual actuators which are all connected to the same (reset) driver. Various possible configurations using multiple EAP devices to enable electrical reset functionality are explained above.
9. When a new pattern of actuation is required, addressing of the array proceeds again in the line-at-a-time manner described above, whereby a new pattern of actuation can be created.

A second example of passive matrix drive scheme is a modification to the drive scheme explained with reference to Fig. 5 to provide addressing a line at a time, and also resetting a line at a time. This requires a modification only to step 8 above.

When a new EAP actuation pattern is required, a reset is applied only to one row of the array at a time. Subsequently, the reset row is addressed in the line-at-a-time manner described above, whereby a new pattern of actuation can be created in that row.

To reset one row, the EAP devices in all other rows must have a voltage below Vbi+Vdr to avoid resetting them. Furthermore, to avoid any EAP response, the other rows should be maintained at 0V. The EAP devices in the row being reset must have a voltage applied which exceeds Vres. For example, the row to be reset may have -Vres applied and all other rows may be held at 0V. The columns may all be held at 0V.

In this way, only those rows which require resetting need to be addressed, which improves the resetting time of the array. In addition, the EAP devices in the non-reset rows will continue to carry out their actuation without an interruption of actuation.

As mentioned above, various reset mechanisms are possible. Fig. 3 shows one possible reset mechanism based on the application of a force.

Alternatively the EAP devices can be glued together, but still can be activated separately from each other. In this case, when one EAP device is activated both EAP devices will bend since they are glued together, but the force acting on the bistable lid is only delivered by one EAP. Again, only when the second EAP is activated is sufficient force generated to bring the bistable lid in the other state.

The drive scheme explained above uses row by row addressing of the EAP devices. In other embodiments, it may be desired to address several rows of EAP devices (with the same set of EAP actuation states) at the same moment, whereby the addressing will proceed more quickly. This is achieved by applying an addressing voltage to more than one row of EAP devices at the same time.

Clearly, as the array as drawn is symmetric it would also be possible to apply the addressing driver to the columns and the data driving to the rows, whereby the array would be addressed one column (or multiple columns) at a time.

In the above examples, only a two level data driver is considered (0V and Vdr). This will result in the lowest cost driver IC's. However in alternative embodiments it may be preferred to also leave the EAP devices partially actuated after the voltage is removed - for example as would be possible for the multi-stable actuator of Fig. 8. To enable this, a data driver with multiple data voltages up to Vdr may be used.

Reduced voltage drivers may also be possible for actuators with a perfect step function displacement as shown in Fig. 8. This means Vdr=0. Reduced voltage drivers may be used for example when the magnitude of the voltage Vbi is at least five times the magnitude of the drive voltage Vdr. For a perfect step as shown in Fig. 8, the columns may then be driven with voltages V1>Vbi/2 with rows at V2 = -Vbi/2.

VI is slightly larger than Vbi/2, for instance Vbi/2 + Δ. Together VI + V2 > Vbi is enough to realize an actuated state which will be retained upon removal of voltage. This has an advantage that the driving voltage by each driver can be kept as low as possible (which limits cost of the ICs). It also ensures that the voltage on the non-actuated EAP devices in the matrix is much lower than Vbi, which allows for some margin should the bistable voltage of the EAP decrease over time or due to temperature fluctuations. Also the non-actuated EAP devices are only electrically stressed by Vbi/2 instead of Vbi, which could also increase lifetime.

All values of VI up to Vbi and V2 up to Vdr are also possible as intermediate solutions, when a trade-off between driving voltage and EAP actuation range is needed.

In the above embodiments, a negative voltage is applied to the rows to be addressed and a positive voltage is applied to the data lines. It is possible to reverse the polarity of both voltages whilst obtaining the same actuation. Indeed, in further embodiments it may be preferred to invert the polarity of the voltages at regular intervals to provide inversion driving which can be used to prevent deterioration of the performance of the EAP device over time.

Thus, the device of the invention may be used as a single actuator, or else there may be a line or array of the devices, for example to provide control of a 2D or 3D contour.

The invention can be applied in many EAP applications, including examples where a passive matrix array of actuators is of interest, in particular as a result of the threshold function described above for some actuator examples.

In many applications the main function of the product relies on the (local) manipulation of human tissue, or the actuation of tissue contacting interfaces. In such applications EAP actuators provide unique benefits mainly because of the small form factor, the flexibility and the high energy density. Hence EAP's can be easily integrated in soft, 3D-shaped and / or miniature products and interfaces. Examples of such applications are:
Skin cosmetic treatments such as skin actuation devices in the form of EAP-based skin patches which apply a constant or cyclic stretch to the skin in order to tension the skin or to reduce wrinkles;
Respiratory devices with a patient interface mask which has an EAP-based active cushion or seal, to provide an alternating normal pressure to the skin which reduces or prevents facial red marks;
Electric shavers with an adaptive shaving head. The height of the skin contacting surfaces can be adjusted using EAP actuators in order to influence the balance between closeness and irritation;
Oral cleaning devices such as an air floss with a dynamic nozzle actuator to improve the reach of the spray, especially in the spaces between the teeth. Alternatively, toothbrushes may be provided with activated tufts;
Consumer electronics devices or touch panels which provide local haptic feedback via an array of EAP transducers which is integrated in or near the user interface;
Catheters with a steerable tip to enable easy navigation in tortuous blood vessels.

Another category of relevant application which benefits from EAP actuators relates to the modification of light. Optical elements such as lenses, reflective surfaces, gratings etc. can be made adaptive by shape or position adaptation using EAP actuators. Here the benefits of EAPs are for example the lower power consumption.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A system comprising:
a passive matrix array of actuation devices,
first signal lines and second signal lines for providing a drive signal to an actuation device; and
a driver arrangement for providing at least two possible signal levels to the first signal lines and at least two possible signal levels to the second signal lines, the signals being provided such that the drive signal received by an actuation device is a combination of one signal level of the first signal lines and one signal of the second signal lines,
wherein each actuation device comprises:
- an actuation structure comprising a carrier (50, 60, 70) and an electroactive material (52, 62, 64, 72) attached to the carrier for causing bending and/or a change of bending of at least the carrier in response to a driving of the electroactive material; and
- a mechanical structure (56, 58, 80) for defining at least a first stable mechanical state and a second stable mechanical state different from the first stable mechanical state of the actuation structure by mechanically constraining the actuation structure in a bent configuration in at least one of the first and second stable mechanical states,
wherein upon the driving, the actuation structure can switch from the first stable mechanical state to the second stable mechanical state,
wherein only one of the four possible combined signal levels provides a switching from the first stable state to the second stable state of the device, and
**characterized in that** the actuation structure is substantially flat in one of the first and second stable mechanical states when the actuation device is not driven.

2. A system as claimed in claim 1, wherein:
- the carrier (60) has a first side and a second side opposite to the first side, wherein the electroactive material (62) is attached to the first side; and
- the actuator structure comprises a further electroactive material (64) attached to the second side, the further electroactive material being for causing bending and/or a change of bending of the actuation structure in response to a further driving of the electroactive material so that, upon the further driving, the actuation structure can switch from the second stable mechanical state to the first stable mechanical state.

3. A system as claimed in claim 1 or 2, wherein the carrier, and any electroactive materials are arranged as a stack of layers.

4. A system as claimed in any of the previous claims, wherein the carrier (70) has an area, and the electroactive material (72) and/or the further electroactive material extend only over a portion of the area.

5. A system as claimed in any of the previous claims, wherein the mechanical structure comprises a retaining device (80), which has a plurality of retaining positions (80a, 80b) at which the actuation structure can be retained in a stable mechanical state, each retaining position corresponding to a different actuator position at least one of the retaining positions mechanically constraining the actuation structure in the bent configuration in at least one of the first and second stable mechanical states.

6. A system as claimed in claim 5, wherein the actuation structure includes a fixed edge fixed to the constraining arrangement and a movable edge, and the retaining device is for retaining a movable edge (86) of the actuation structure at different distances from the fixed edge of the actuation structure, and comprises a plurality of retaining notches.

7. A system as claimed in any of the previous claims, wherein the actuation devices each comprise an electrode arrangement for applying an electrical signal to the electroactive material for the driving and/or the further driving.

8. A system as claimed in any of the preceding claims, wherein for each actuation device:
the drive signal having a combined signal level below a first threshold Vbi provides actuation from the first stable state towards the second stable state but with return to the first stable state upon removal of the drive signal; and
the drive signal having a combined signal level above a second threshold provides actuation from the first stable state to the second stable state without return of the first stable state upon removal of the drive signal, and wherein the second threshold has a magnitude which is a first margin Vdr greater than the magnitude of the first threshold Vbi.

9. A system as claimed in claim 8, wherein, for one of the first signal line and the second signal line, the two possible signal levels are zero and the magnitude of the first threshold Vbi and, for the other of the first signal line and the second signal line, the two possible signal levels are zero and the magnitude of the first margin Vdr, wherein the non-zero signal levels have opposite polarity.

10. A system as claimed in claim 8 or 9, wherein:
- the magnitude of the first threshold Vbi is greater than the magnitude of the first margin Vdr, or
- the magnitude of the first threshold Vbi is at least five times the magnitude of the first margin Vdr.

11. A system as claimed in any of the claims 8 to 10, wherein the driver is arranged to:
- for each of the plurality of actuation devices, provide a reset drive signal having a combined signal level above a third threshold Vres which provides a reset to the first stable state upon removal of the drive signal; and
- the system is adapted to receive an external input in the form of a mechanical reset for the plurality of the actuation devices.

12. A method of operating a system as claimed in any preceding claim, the method comprising providing at least two possible signal levels to a first signal line and at least two possible signal levels to a second signal line, the signals being provided such that the drive signal received by an actuation device is a combination of one signal level of the first signal line and one of the second signal line, wherein only one of the four possible combined signal levels provides a switching from the first stable state to the second stable state of the actuation device.

## Patentansprüche

1. Ein System, das Folgendes umfasst:
eine passive Matrixanordnung von Auslösegeräten,
erste und zweite Signalleitungen zum Bereitstellen eines Ansteuersignals für ein Auslösegerät; und
eine Antriebsanordnung zum Bereitstellen von mindestens zwei möglichen Signalpegeln für die ersten Signalleitungen sowie von mindestens zwei möglichen Signalpegeln für die zweiten Signalleitungen, wobei die Signale so bereitgestellt werden, dass es sich bei dem vom Auslösegerät empfangenen Ansteuersignal um eine Kombination des Signalpegels der ersten Signalleitungen mit einem Signal der zweiten Signalleitungen handelt,
wobei die einzelnen Auslösegeräte Folgendes umfassen:
- eine Auslösestruktur, die einen Träger (50, 60, 70) und ein elektroaktives Material (52, 62, 64, 72) umfasst, das am Träger angebracht ist, um ein Biegen und/oder eine Veränderung der Biegung zumindest des Trägers verursacht, wenn das elektroaktive Material angesteuert wird;
und
- eine mechanische Struktur (56, 58, 80) zum Definieren mindestens eines ersten stabilen mechanischen Zustands und eines zweiten stabilen mechanischen Zustands, der sich vom ersten stabilen mechanischen Zustand der Auslösestruktur unterscheidet. Hierzu wird die Auslösestruktur in mindestens einem der ersten und zweiten stabilen mechanischen Zustände mechanisch auf einen gebogenen Zustand beschränkt, wobei die Auslösestruktur beim Ansteuern vom ersten stabilen mechanischen Zustand in den zweiten stabilen mechanischen Zustand wechseln kann,
wobei nur einer der vier möglichen kombinierten Signalpegel ein Umschalten vom ersten stabilen Zustand in den zweiten stabilen Zustand des Geräts zulässt, und
wobei die Auslösestruktur in einem der ersten und zweiten stabilen mechanischen Zustände im Wesentlichen flach ist, wenn das Auslösegerät nicht angesteuert wird.

2. Ein System gemäß Anspruch 1; wobei:
- der Träger (60) eine erste Seite und eine der ersten Seite gegenüberliegende zweite Seite umfasst, wobei das elektroaktive Material (62) an der ersten Seite angebracht ist; und
- die Auslösestruktur ein weiteres elektroaktives Material (64) umfasst, das an der zweiten Seite angebracht ist, wobei das weitere elektroaktive Material dazu dient, ein Biegen und/oder eine Veränderung der Biegung der Auslösestruktur zu verursachen, wenn das elektroaktive Materials zusätzlich angesteuert wird, sodass die Auslösestruktur beim zusätzlichen Ansteuern vom zweiten stabilen mechanischen Zustand in den ersten stabilen mechanischen Zustand wechseln kann.

3. Ein System gemäß Anspruch 1 oder 2, wobei der Träger und alle elektroaktiven Materialien als geschichteter Stapel angeordnet sind.

4. Ein System gemäß einer der vorhergehenden Ansprüche, wobei der Träger (70) über eine Fläche verfügt, und wobei sich das elektroaktive Material (72) und/oder das zusätzliche elektroaktive Material nur über einen Teil der Fläche erstrecken.

5. Ein System gemäß einer der vorhergehenden Ansprüche, wobei die mechanische Struktur eine Haltevorrichtung (80) umfasst, die eine Vielzahl von Haltepositionen (80a, 80b) aufweist, an denen die Auslösestruktur in einem stabilen mechanischen Zustand gehalten werden kann, und wobei die einzelnen Halteposition jeweils einer anderen Auslöserposition entsprechen, und wobei mindestens eine der Haltepositionen die Auslösestruktur in mindestens einem der ersten und zweiten stabilen mechanischen Zustände mechanisch auf einen gebogenen Zustand beschränkt.

6. Ein System gemäß Anspruch 5, wobei die Auslösestruktur eine feste, an der Beschränkungsanordnung angebrachte unbewegliche Kante sowie eine bewegliche Kante umfasst, und wobei die Haltevorrichtung mehrere Haltekerben aufweist und die bewegliche Kante (86) der Auslösestruktur in verschiedenen Abständen zur unbeweglichen Kante der Auslösestruktur hält.

7. Ein System gemäß einer der vorhergehenden Ansprüche, wobei die Auslösegeräte jeweils eine Elektrodenanordnung zum Anlegen eines elektrischen Signals an das elektroaktive Material für das Ansteuern und/oder das zusätzliche Ansteuern umfassen.

8. Ein System gemäß einer der vorhergehenden Ansprüche, wobei für die einzelnen Auslösegeräte gilt:
das Ansteuersignal mit einem kombinierten Signalpegel unterhalb eines ersten Schwellenwerts Vbi vom ersten stabilen Zustand in Richtung des zweiten stabilen Zustands ansteuert, wobei jedoch zum ersten stabilen Zustand zurückgekehrt wird, wenn das Ansteuersignal entfernt wird; und
das Ansteuersignal mit einem kombinierten Signalpegel über einem zweiten Schwellenwert vom ersten stabilen Zustand in den zweiten stabilen Zustand ansteuert, wobei nach dem Entfernen des Ansteuersignals nicht in den ersten stabilen Zustand zurückgekehrt wird, und wobei der zweite Schwellenwert eine Größe aufweist, die um die erste Spanne Vdr größer ist, als die Größe des ersten Schwellenwerts Vbi.

9. Ein System gemäß Anspruch 8, wobei für die eine der ersten und zweiten Signalleitungen die zwei möglichen Signalpegel Null und der Größe des ersten Schwellenwerts Vbi entsprechen, wobei für die andere der ersten und zweiten Signalleitungen die zwei möglichen Signalpegel Null und der Größe der ersten Spanne Vdr entsprechen, wobei die von Null abweichenden Signalpegel jeweils eine gegensätzliche Polarität aufweisen.

10. Ein System gemäß Anspruch 8 oder 9, wobei:
- die Größe des ersten Schwellenwerts Vbi größer ist, als die Größe der ersten Spanne Vdr, oder
- die Größe des ersten Schwellenwerts Vbi mindestens fünfmal so groß wie die Größe der ersten Spanne Vdr ist.

11. Ein System gemäß einer der Ansprüche 8 bis 10, wobei der Antrieb Folgende Schritte durchführt:
- Bereitstellen eines Rücksetz-Ansteuersignals mit einem kombinierten Signalpegel über dem dritten Schwellenwert Vres für jedes der Auslösegeräte, um beim Entfernen des Ansteuersignals in den ersten stabilen Zustand zurückzukehren; und
- Abrufen einer externen Eingabe in Form eines mechanischen Zurücksetzens der Auslösegeräte.

12. Eine Methode zum Betreiben eines Systems gemäß einer der vorhergehenden Ansprüche, wobei die Methode das Bereitstellen von mindestens zwei möglichen Signalpegeln für eine erste Signalleitung sowie von mindestens zwei möglichen Signalpegeln für eine zweite Signalleitung umfasst, wobei die Signale so bereitgestellt werden, dass es sich bei dem vom Auslösegerät empfangenen Ansteuersignal um eine Kombination aus einem Signalpegel der ersten Signalleitung sowie einem der zweiten Signalleitung handelt, und wobei nur einer der vier möglichen kombinierten Signalpegel ein Wechseln vom ersten stabilen Zustand in den zweiten stabilen Zustand des Auslösegeräts ermöglicht.

## Revendications

1. Système comprenant :
un réseau matriciel passif de dispositifs d'actionnement,
des premières lignes de signaux et des secondes lignes de signaux pour fournir un signal d'attaque à un dispositif d'actionnement ; et
un agencement d'attaque pour fournir au moins deux niveaux de signaux possibles aux premières lignes de signaux et au moins deux niveaux de signaux possibles aux secondes lignes de signaux, les signaux étant fournis de telle sorte que le signal d'attaque reçu par un dispositif d'actionnement est une combinaison d'un niveau de signal des premières lignes de signaux et d'un signal des secondes lignes de signaux,
dans lequel chaque dispositif d'actionnement comprend :
- une structure d'actionnement comprenant un support (50, 60, 70) et une matière électroactive (52, 62, 64, 72) attachée au support pour provoquer une flexion et/ou un changement de flexion d'au moins le support en réponse à une attaque de la matière électroactive ; et
- une structure mécanique (56, 58, 80) pour définir au moins un premier état mécanique stable et un second état mécanique stable différent du premier état mécanique stable de la structure d'actionnement par contrainte mécanique de la structure d'actionnement dans une configuration courbée dans le premier et/ou le second état mécanique stable,
dans lequel lors de l'attaque, la structure d'actionnement peut passer du premier état mécanique stable au second état mécanique stable,
dans lequel un seul des quatre niveaux de signaux combinés possibles assure une commutation du premier état stable au second état stable du dispositif, et
**caractérisé en ce que** la structure d'actionnement est sensiblement plate dans le premier ou le second état mécanique stable lorsque le dispositif d'actionnement n'est pas attaqué.

2. Système selon la revendication 1, dans lequel :
- le support (60) comporte une première face et une seconde face opposée à la première face, dans lequel la matière électroactive (62) est attachée à la première face ; et
- la structure d'actionneur comprend une autre matière électroactive (64) attachée à la seconde face, l'autre matière électroactive étant destinée à provoquer une flexion et/ou un changement de flexion de la structure d'actionnement en réponse à un autre attaque de la matière électroactive de telle sorte que, lors de l'autre attaque, la structure d'actionnement peut passer du second état mécanique stable au premier état mécanique stable.

3. Système selon la revendication 1 ou 2, dans lequel le support et toute matière électroactive sont conçus sous la forme d'un empilement de couches.

4. Système selon l'une quelconque des revendications précédentes, dans lequel le support (70) comporte une zone, et la matière électroactive (72) et/ou l'autre matière électroactive ne s'étendent que sur une partie de ladite zone.

5. Système selon l'une quelconque des revendications précédentes, dans lequel la structure mécanique comprend un dispositif de retenue (80), lequel comporte une pluralité de positions de retenue (80a, 80b) auxquelles la structure d'actionnement peut être maintenue dans un état mécanique stable, chaque position de retenue correspondant à une position d'actionneur différente de l'au moins une des positions de retenue contraignant mécaniquement la structure d'actionnement dans la configuration courbée dans le premier ou le second état mécanique stable.

6. Système selon la revendication 5, dans lequel la structure d'actionnement comprend un bord fixe fixé à l'agencement de contrainte et un bord mobile, et le dispositif de retenue sert à retenir le bord mobile (86) de la structure d'actionnement à différentes distances du bord fixe de la structure d'actionnement, et comprend une pluralité d'encoches de retenue.

7. Système selon l'une quelconque des revendications précédentes, dans lequel les dispositifs d'actionnement comprennent respectivement un agencement d'électrodes pour appliquer un signal électrique à la matière électroactive pour l'attaque et/ou l'autre attaque.

8. Système selon l'une quelconque des revendications précédentes, dans lequel pour chaque dispositif d'actionnement :
le signal d'attaque présentant un niveau de signal combiné inférieur à un premier seuil Vbi fournit l'actionnement du premier état stable vers le second état stable, mais avec le retour au premier état stable lors de la suppression du signal d'attaque ; et
le signal d'attaque présentant un niveau de signal combiné supérieur à un deuxième seuil fournit l'actionnement du premier état stable au second état stable sans retour du premier état stable lors de la suppression du signal d'attaque, et
dans lequel le deuxième seuil présente une amplitude, laquelle est une première marge Vdr supérieure à l'amplitude du premier seuil Vbi.

9. Système selon la revendication 8, dans lequel, pour la première ligne de signal ou la seconde ligne de signal, les deux niveaux de signal possibles sont zéro et l'amplitude du premier seuil Vbi et, pour l'autre de la première ligne de signal et de la seconde ligne de signal, les deux signaux possibles les niveaux sont nuls et la grandeur de la première marge Vdr, dans lequel les niveaux de signal non nuls ont une polarité opposée.

10. Système selon la revendication 8 ou 9, dans lequel :
- la grandeur du premier seuil Vbi est supérieure à la grandeur de la première marge Vdr, ou
- la grandeur du premier seuil Vbi est au moins cinq fois la grandeur de la première marge Vdr.

11. Système selon l'une quelconque des revendications 8 à 10, dans lequel le dispositif d'attaque est conçu :
- pour fournir, pour chaque dispositif de la pluralité de dispositifs d'actionnement, un signal de commande de réinitialisation présentant un niveau de signal combiné supérieur à un troisième seuil Vres, lequel fournit une réinitialisation au premier état stable lors de la suppression du signal de commande ; et
- ledit système est conçu pour recevoir une entrée externe sous la forme d'une réinitialisation mécanique pour la pluralité des dispositifs d'actionnement.

12. Procédé de fonctionnement d'un système selon l'une quelconque des revendications précédentes, ledit procédé comprenant la fourniture d'au moins deux niveaux de signal possibles à la première ligne de signal et au moins deux niveaux de signal possibles à la seconde ligne de signal, les signaux étant fournis de telle sorte que le signal d'attaque reçu par un dispositif d'actionnement est une combinaison d'un niveau de signal de la première ligne de signal et de l'une de la seconde ligne de signal, dans lequel un seul des quatre niveaux de signaux combinés possibles fournit une commutation du premier état stable au second état stable du dispositif d'actionnement.
